**Europäisches Patentamt**

**European Patent Office**

**Office européen des brevets**

(19)

(11) Veröffentlichungsnummer: **0 262 293 B1**

# (12) EUROPÄISCHE PATENTSCHRIFT

(45) Veröffentlichungstag der Patentschrift:
27.12.90

(21) Anmeldenummer: 87106436.6

(22) Anmeldetag: 04.05.87

(51) Int. Cl.⁵: **G01R 15/02, H01F 40/06**

(54) **Messwandler zum Messen des in einem elektrischen Leiter fliessenden Stromes.**

(30) Priorität: 29.09.86 CH 3899/86

(43) Veröffentlichungstag der Anmeldung:
06.04.88 Patentblatt 88/14

(45) Bekanntmachung des Hinweises auf die Patenterteilung:
27.12.90 Patentblatt 90/52

(84) Benannte Vertragsstaaten:
AT BE CH DE ES FR GB IT LI NL SE

(56) Entgegenhaltungen:
EP-A- 0 082 082
WO-A-83/01535
DE-A- 3 619 423
DE-B- 1 079 192
DE-B- 1 133 817

dtv-Lexikon der Physik, Band 8 (1971), Deutscher Taschenbuch Verlag GmbH & Co. KG, München, Seite 245

(73) Patentinhaber: **Landis & Gyr Betriebs AG,**
CH-6301 Zug(CH)

(72) Erfinder: **Brandenberg, Urs, Loretohöhe 3,**
CH-6300 Zug(CH)
Erfinder: **Seitz, Thomas, Hasenbühlweg 7,**
CH-6300 Zug(CH)

**Beschreibung**

Die Erfindung bezieht sich auf einen Messwandler zum Messen des in einem elektrischen Leiter fliessenden Stromes gemäss dem Oberbegriff des Anspruchs 1.

Derartige Messwandler werden z.B. in Elektrizitätszählern verwendet zur Ermittlung einer an einen Verbraucher abgegebenen Momentanleistung. In diesem Fall wird der Momentanwert eines elelktrischen Stromes mit der Anordnung gemessen und anschliessend mit dem Momentanwert einer Versorgungsspannung multipliziert.

Ein Messwandler gemäss dem Oberbegriff des Anspruchs 1 ist aus der EP 0 082 082 A1 bekannt, in der ein U-förmiger gebogener Stromleiter von einem zu messenden Strom durchflossen ist. Dabei ist eine Luftspule in einem mit einem Deckel versehenen elektrisch isolierenden Behälter untergebracht, der in der Nähe des U-förmigen Teils des Stromleiters zwischen dessen Hin- und Rückleiter angeordnet ist. Die Längsachse der Luftspule verläuft parallel zu den Magnetfeldern, die durch den in einem Hin- und Rückleiter des Stromleiters fliessenden Strom erzeugt werden. Der U-förmige Teil des Stromleiters mit der dazugehörigen Luftspule und deren Behälter sind in einer mit einem Boden versehenen dosenartigen Abschirmung untergebracht, so dass die Luftspule auch dem vom im U-förmigen Teil des stromleiters fliessenden Strom erzeugten Magnetfeld ausgesetzt ist. Letzteres Magnetfeld wird somit je nach Stromrichtung teilweise mitgemessen und beeinflusst somit da, da nur teilweise gemessen, in unübersichtlicher Weise negativ das Gesamtmessresultat. Die Montage der Messanordnung erfolgt relativ kompliziert, da deren einzelne Bauteile mechanisch unabhängig voneinander sind und einzeln zeitlich nacheinander in einer ihnen zugeordneten äusseren Anordnung hineingeschoben werden müssen. Dies bedingt unter anderem, dass die Luftspule zuerst in ihren Behälter hineingeschoben werden muss, dann ihre Position innerhalb dieses Behälters zwecks Eichung der Messanordnung relativ kompliziert mittels einer Schraube eingestellt werden muss und dann erst der Deckel des Behälters geschlossen werden kann.

Aus der DE-AS 1 133 817 ist ausserdem ein Stromwandler mit Bandringkern bekannt zur Messung pulsierender Gleichströme. Die Konstruktion des Stromwandlers gestattet es, zwei in gleicher Höhe nebeneinander geführte, als Primärwicklung dienende Stromschienen in entgegengesetzter Richtung durch das Fenster des Bandringkerns zu führen, um die Polarität eines jeden zeitlich zweiten Gleichstromimpulses umzukehren und so einen rechteckförmigen Wechselstrom zu erzeugen, der mit Hilfe einer auf dem Bandringkern gewickelten Sekundärwicklung gemessen werden kann.

Der Erfindung liegt die Aufgabe zugrunde, den Aufbau, die Montage und die Effizienz des bekannten Messwandlers gemäß EP-A 0 082 082 derart zu verbessern, dass die Montage des Messwandlers einerseits sehr einfach und andererseits unkritisch gegenüber mechanischen Toleranzen ist und dass der Messwandler, unter Beibehaltung seiner Unempfindlichkeit gegenüber Magnetfremdfeldern, besonders präzis, einfach, kostengünstig und zuverlässig ist sowie ein grosses Ausgangssignal besitzt.

Die genannte Aufgabe wird erfindungsgemäss durch die im Kennzeichen des Anspruchs 1 angegebenen Merkmale gelöst.

Ausführungsbeispiele der Erfindung sind in der Zeichnung dargestellt und werden im folgenden näher beschrieben.

Es zeigen:

Fig. 1 einen ersten Querschnitt A–B des schematischen Aufbaus einer ersten Variante eines Messwandlers,

Fig. 2 einen zweiten Querschnitt C–D des Aufbaus der ersten Variante,

Fig. 3 einen Aufbau einer zweiten Variante eines Messwandlers und

Fig. 4 einen Aufbau einer dritten Variante eines Messwandlers.

Gleiche Bezugszahlen bezeichnen in allen Figuren der Zeichnung gleiche Teile.

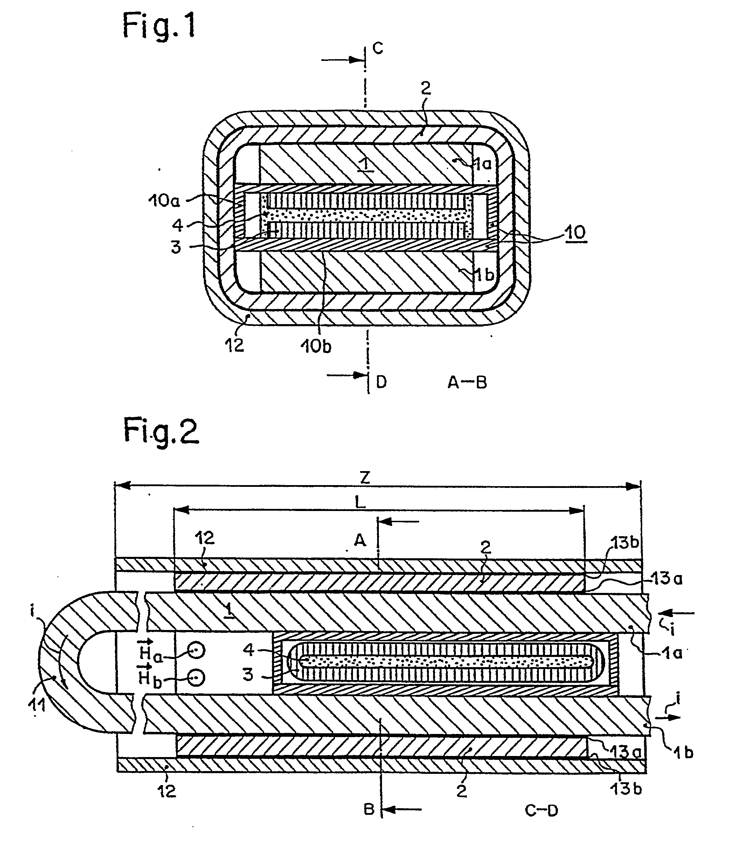

Der in den Figuren 1 und 2 dargestellte Messwandler zum Messen des in einem elektrischen Leiter 1 fliessenden Stromes i enthält mindestens eine ferromagnetische Abschirmung 2 und mindestens eine vom elektrischen Leiter 1 elektrisch isolierte Luftspule 3;4, die aus einer Spulenwicklung 3 besteht, die auf einem Spulenkörper 4 gewickelt ist. Eine Luftspule ist dabei ganz allgemein definiert als eine Spule, die keinen ferromagnetischen Kern besitzt. Die Luftspule 3;4, die in der Zeichnung nicht massstabgetreu dargestellt ist, ist zwischen je einem in der Nähe, d.h. in einem Abstand von höchstens einem Millimeter von der Mantelfläche der Luftspule 3;4 annähernd parallel zueinander verlaufenden Hin- und Rückleiter 1a und 1b des elektrischen Leiters 1 derartig angeordnet, dass ihre Längsachse annähernd parallel zur Richtung der Magnetfelder $\vec{H}_a$ und $\vec{H}_b$ verläuft. Das Magnetfeld $\vec{H}_a$ wird durch den im Hinleiter 1a fliessenden Strom i erzeugt, während das Magnetfeld $\vec{H}_b$ durch den im Rückleiter 1b fliessenden Strom i erzeugt wird. Im Raum zwischen dem Hinleiter 1a und dem zu ihm parallelen Rückleiter 1b sind die beiden Magnetfelder $\vec{H}_a$ und $\vec{H}_b$ am Ort der Luftspule 3;4 mit gleichem Richtungssinn parallel zueinander. Die Luftspule 3;4 ist eine flache Spule, die bekanntlich mindestens eine Dimension besitzt, die bedeutend kleiner ist als eine der beiden anderen Dimensionen, wobei die flache Spule z.B. eine Flachspule oder eine flache Zylinderspule ist, und der Abstand zwischen der Mantelfläche der Luftspule 3;4 und dem Hin- und Rückleiter 1a und 1b ist jeweils gleich der minimalen, durch eine erforderliche Isolationsspannung gegebenen Grösse von höchstens einem Millimeter. Dadurch bedingt, ist die magnetische Kopplung zwischen dem Leiter 1 und der Luftspule 3;4 maximal sehr gross, da der magnetische Fluss der vom Strom i erzeugten Magnetfelder $\vec{H}_a$ und $\vec{H}_b$ möglichst vollständig von der Luftspule 3;4 erfasst wird und sich diese in axialer Richtung über eine möglichst kleine Teillänge der vom Strom i erzeugten Magnetfeldlinien erstreckt.

Die Luftspule 3;4 ist vorzugsweise in einem Gehäuse 10 aus elektrisch isolierendem Material angeordnet, dessen Wände ihrerseits die elektrische Isolation der Luftspule 3;4 gegenüber dem Hin- und Rückleiter 1a und 1b bilden. Das Gehäuse 10 besteht mit Vorteil aus Keramik und besitzt vorzugsweise einen Boden 10a und einen Gehäusedeckel 10b. Die Luftspule 3;4 ist in vorteilhafter Weise auf einen Träger aus Isoliermaterial angeordnet, auf dem z.B. noch zusätzlich elektronische Bauelemente vorhanden sind, wobei vorzugsweise der Boden 10a des Gehäuses 10 dieser Träger ist. Dies gestattet eine einfache, präzise, zuverlässige und gegenüber mechanischen Toleranzen unkritische Montage des Gehäuses 10 und der Luftspule 3;4, die beide zusammen eine Baueinheit bilden. Als Material für die ferromagnetische Abschirmung eignet sich wegen der hohen Permeabilität vorzugsweise eine Eisen-Nickel-Legierung, wie z.B. Permenorm, Vacoperm, Trafoperm, Permax, Ultraperm oder Mumetall. Die ferromagnetische Abschirmung 2 besitzt die Gestalt eines rohrförmiger Ringes, der vorzugsweise aus mindestens einem ringförmig gebogenen Blech besteht, was eine Herstellung stark vereinfacht, und der sowohl den Hin- als auch den Rückleiter 1a und 1b elektrisch isoliert umgibt. Die Länge L des Ringes ist grösser als seine grösste Lichte weite, so dass er die Luftspule 3;4 sehr gut gegen die Wirkung äusserer Fremdmagnetfelder abschirmt. Der elektrische Leiter 1 besitzt z.B. einen rechteckförmigen Querschnitt und der rohrförmige Ring weist dann auch in bevorzugter Weise senkrecht zu seiner Längsachse einen rechteckförmigen Querschnitt aus. Der elektrische Leiter 1 bildet vorzugsweise eine U-förmige Schleife 11, deren Hin- und Rückleiter die parallel zueinander verlaufenden Hin- und Rückleiter 1a und 1b des elektrischen Leiters 1 sind. Der rechteckförmige Querschnitt des elektrischen Leiters 1 beträgt z.B. 2 mm x 10 mm für einen Strom i von 100A. Auf dem Träger können innerhalb oder ausserhalb des Gehäuses 10 noch zusätzlich elektronische, nicht dargestellte Bauelemente angeordnet sein, die z.B. Teil der Beschaltungselektronik des Messwandlers sind.

In der Fig. 1 wurde angenommen, dass die Breite des Gehäuses 10 grösser ist als die Breite des elektrischen Leiters 1. In diesem Fall füllt im Querschnitt A–B das Gehäuse 10 z.B. den Raum zwischen dem Hin- und Rückleiter 1a und 1b der Schleife 11 vollständig aus. Die Breite des Gehäuses 10 kann auch gleich oder kleiner sein als die Breite des elektrischen Leiters 1. Im letzten Fall füllt im Querschnitt A-B das Gehäuse 10 den Raum zwischen dem Hin- und Rückleiter 1a und 1b der Schleife 11 nur teilweise aus. In allen Fällen umgibt der Ring der Länge L den Hin- und Rückleiter 1a und 1b der Schleife 11 sowie das Gehäuse 10. Der Hin- und der Rückleiter 1a und 1b der Schleife 11 durchqueren in Längsrichtung den Hohlraum zwischen dem Gehäuse 10 und dem Ring z.B. derart, dass sie nach Möglichkeit sowohl räumlichen Kontakt mit dem Gehäuse 10 als auch elektrisch isolierten räumliche Kontakt mit dem Ring besitzen. Zwischen dem Ring einerseits und dem den Ring durchquerenden Hin- und Rückleiter 1a und 1b andererseits ist somit eine Isolationsschicht 13a vorhanden (siehe Fig. 1 und Fig. 2).

Der Ring ist vorteilhaft auf seiner Mantelfläche vollständig von einer annähernd parallelen ringförmigen und breiteren Aussenabschirmung 12 umgeben. Zwischen dem Ring und der Aussenabschirmung 12 befindet sich z.B. eine Isolierschicht 13b. Die Aussenabschirmung 12 hat eine Länge Z, die grösser ist als die Länge L des Ringes, damit dessen stirnseitige Flächen noch teilweise mit abgeschirmt werden. Die Länge Z beträgt z.B. 30 mm. Die Aussenabschirmung 12 besteht vorteilhaft aus Tiefziehstahl oder aus einer Eisen-Nickel-Legierung. Die Isolierschicht 13b zwischen Ring und Aussenabschirmung 12 dient hier auch dazu, den räumlichen Abstand zwischen den beiden zu vergrössern, was die Schirmwirkung der Aussenabschirmung 12 verbessert. Dieser räumliche Abstand beträgt z. B. 0,05 mm. Die Aufgabe der Aussenabschirmung 12 ist es, den hochpermeablen, aber leicht sättigenden Ring, der ja als Schirm wirksam ist, bei starken äusseren Fremdmagnetfeldern zu entlasten. Der Ring und die Aussenabschirmung 12 wirken somit als Doppelschirm. Ohne Aussenabschirmung 12 bleibt der durch den Ring gebildete Schirm ungesättigt bis zu einem Wert des äusseren Fremdmagnetfeldes von etwa 50A/cm. Beim Vorhandensein des Doppelschirms dagegen bleibt der durch den Ring gebildete Schirm ungesättigt bis zu einem Wert des äusseren Fremdmagnetfeldes von etwa 200A/cm. Die in der Luftspule 3;4 induzierte Spannung ist proportional d $(\vec{H}_a + \vec{H}_b)$/dt, d. h. bei sinusförmigen Magnetfeldern $\vec{H}_a$ und $\vec{H}_b$ proportional der Summe $(\vec{H}_a + \vec{H}_b) = 2\,\vec{H}_a$, da beide Magnetfelder $\vec{H}_a$ und $\vec{H}_b$ gleich gross und gleich gerichtet sind. Bei nichtsinusförmigen Magnetfeldern $\vec{H}_a$ und $\vec{H}_b$ sind die beiden Anschlüsse der Luftspule 3;4 mit einem zweipoligen Eingang eines in der Zeichnung nicht dargestellten Integrators zu verbinden. Das Ausgangssignal dieses Integrators ist dann in jedem Fall proportional $(\vec{H}_a + \vec{H}_b) = 2\,\vec{H}_a$. Der Integrator ist z. B. ein Miller-Integrator, der bekanntlich aus einem Operationsverstärker besteht, dessen Ausgang über einen Kondensator auf den invertierenden Eingang des Operationsverstärkers rückgekoppelt ist. Die beiden Pole des Eingangs des Integrators sind dabei innerhalb desselben über je einen Widerstand mit dem invertierenden bzw. dem nichtinvertierenden Eingang des Operationsverstärkers verbunden.

Durch die besonders enge magnetische Kopplung zwischen dem Hin-und Rückleiter 1a und 1b des Leiters 1 und der Luftspule 3;4 ist der Messwandler besonders präzis und zuverlässig. Die Abschirmung 2 und, wenn vorhanden, die Aussenabschirmung 12 machen ihn unempfindlich gegenüber Magnetfeldern.

Die zweite und dritte Variante unterscheiden sich von der ersten Variante nur durch die Formgebung des elektrischen Leiters 1.

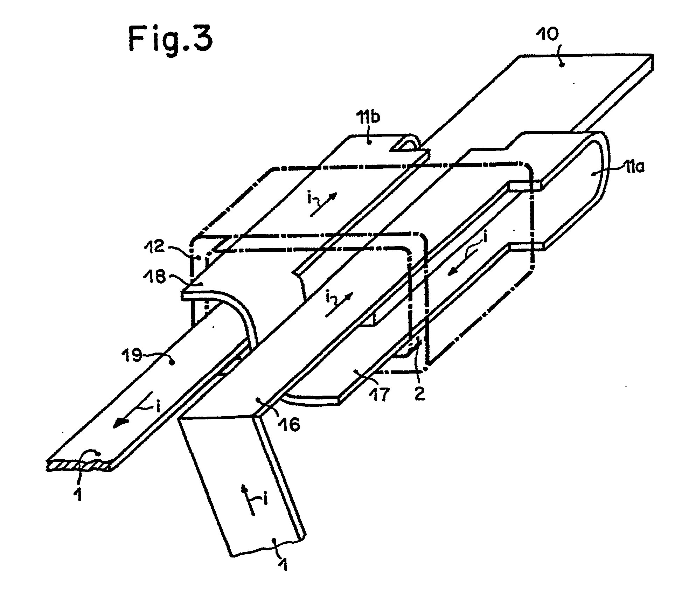

In der in der Fig. 3 dargestellten Anordnung bildet der elektrische Leiter 1 mindestens zwei U-förmige Schleifen 11a und 11b, die seitlich parallel nebeneinander angeordnet und elektrisch in Reihe geschaltet sind. Dabei sind beide Leiter 16 und 17 bzw. 18 und 19 einer jeden Schleife 11a bzw. 11b parallel deckend übereinander angeordnet. Die beiden Hinleiter 16 und 18 einerseits und die beiden Rückleiter 17 und 19 anderseits der beiden Schleifen 11a und 11b sind jeweils in einer gleichen Ebene nebeneinander angeordnet. Das Gehäuse 10 und damit auch die Luftspule 3;4 sind zwischen den beiden Hinleitern 16 und 18 einerseits und den beiden Rückleitern 17 und 19 anderseits angeordnet, wobei alle diese Hin- und Rückleiter in der Nähe des Gehäuses 10 verlaufen. Der Ring und, falls vorhanden, die Aussenabschirmung 12 umgeben seitlich und von ihnen elektrisch isloiert die beiden U-förmigen Schleifen 11a und 11b. Die Anordnung ermöglicht es, ohne die Konfigurationen der ferromagnetischen Abschirmung 2 und des Gehäuses 10 zu ändern, den Messwandler mit halbem Strom, z. B. mit 50A, zu erregen. Dieser halbe Strom erzeugt mit zwei Schleifen 11a und 11b ein gleich grosses Magnetfeld wie der Strom i mit einer einzigen Schleife 11.

Selbstverständlich können die U-förmigen Schleifen 11a und 11b auch deckend ineinander geschoben angeordnet sein. In diesem Fall sind die beiden Hinleiter 16 und 18 einerseits und die beiden Rückleiter 17 und 19 anderseits deckend übereinander statt nebeneinander angeordnet. Die Hin- und Rückleiter 16 bis 19 können dann annähernd doppelt so breit und halb so dick sein.

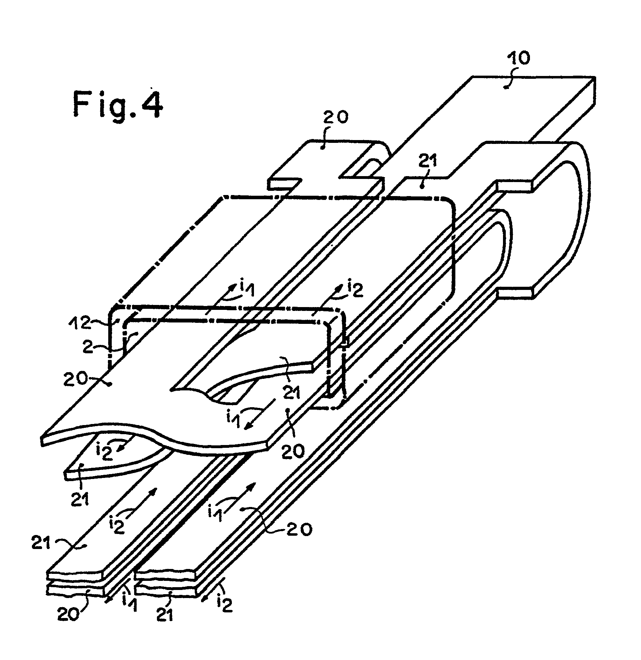

Bei der in der Fig.4 dargestellten dritten Varinate besteht der elektrische Leiter 1 aus zwei Leitern 20 und 21, die mindestens innerhalb des Ringes parallel sind und die mindestens einmal derart angeordnet sind, dass sie den Ring zuerst in der einen Richtung durchqueren, sich dann elektrisch isoliert kreuzen um anschliessend den Ring in umgekehrter Richtung erneut zu durchqueren. Dabei ist das Gehäuse 10 und damit auch die Luftspule 3;4 jeweils für beide Richtungen zwischen den beiden Leitern 20 und 21 angeordnet. Die beiden Leiter 20 und 21 sind z. B. parallel deckend überein angeordnet. Eine Aussenabschirmung 12 umgibt auch hier in vorteilhafter Weise den Ring seitlich. Diese Anordnung wird z. B. in Elektrizitätszählern der USA verwendet und ermöglicht es, ohne die Konfigurationen des Gehäuses 10 und der ferromagnetischen Abschirmung 2 zu ändern, den Messwandler mit zwei unabhängigen einphasigen Strömen $i_1$ und $i_2$ von z. B. je 200A zu erregen, wobei im Extremfall einer der beiden Ströme $i_1$ bzw. $i_2$ Null sein kann. Ein derartiger Gesamtaufbau der Leiter 20 und 21 gestattet es, die Uebertragungskonstanten der beiden Ströme $i_1$ und $i_2$ genau gleich gross zu machen.

## Patentansprüche

1. Messwandler zum Messen des in einem elektrischen Leiter (1) fliessenden Stromes (i) mit einer Luftspule (3;4), einem Gehäuse (10) aus elektrisch isolierendem Material und mindestens einer ferromagnetischen Abschirmung (2), wobei die Luftspule (3;4) in dem Gehäuse (10) und zwischen je einem parallel zueinander verlaufenden Hin- und Rückleiter (1a, 1b) des elektrischen Leiters (1) derart angeordnet ist, dass die Längsachse der Luftspule (3;4) parallel zur Richtung der Magnetfelder ($\vec{H}_a$, $\vec{H}_b$) verläuft, die durch den in dem Hin- und Rückleiter (1a, 1b) fliessenden Strom (i) erzeugt werden, und wobei die ferromagnetische Abschirmung (2) den Hin- und Rückleiter (1a, 1b) elektrisch isoliert umgibt, dadurch gekennzeichnet, dass die ferromagnetische Abschirmung (2) die Gestalt eines rohrförmigen Ringes besitzt, der vom Hin- und Rückleiter (1a, 1b) in Längsrichtung durchquert wird, dass der Abstand zwischen der Mantelfläche der Luftspule (3;4) und dem Hin- und Rückleiter (1a, 1b) jeweils höchstens einen Millimeter beträgt und die Luftspule (3;4) eine flache Spule ist, so dass einerseits der Magnetfluss der Magnetfelder ($\vec{H}_a$, $\vec{H}_b$) möglichst vollständig von der Luftspule (3;4) erfasst wird und sich anderseits die Luftspule (3;4) in axialer Richtung nur über eine möglichst kleine Teillänge der vom Strom (i) erzeugten Magnetfeldlinien erstreckt und dass die Luftspule (3;4) und das Gehäuse (10) zusammen eine Baueinheit bilden, die eine einfache und gegenüber mechanischen Toleranzen unkritische Montage der Luftspule (3;4) zwischen dem Hin- und dem Rückleiter (1a, 1b) gestattet.

2. Messwandler nach Anspruch 1, dadurch gekennzeichnet, dass die ferromagnetische Abschirmung (2) aus mindestens einem ringförmig gebogenen Blech besteht.

3. Messwandler nach Anspruch 2, dadurch gekennzeichnet, dass die Länge (1) des rohrförmigen Ringes grösser ist als seine grösste licht Weite.

4. Messwandler nach Anspruch 2 oder 3, dadurch gekennzeichnet, dass bei einem rechteckförmigen Querschnitt des elektrischen Leiters (1) der zur Längsachse senkrechte Querschnitt des rohrförmigen Ringes ebenfalls rechteckförmig ist.

5. Messwandler nach einem der Ansprüche 1 bis 4, dadurch gekennzeichnet, dass die Wände des Gehäuses (10) die elektrische Isolation der Luftspule (3;4) gegenüber dem Hin- und Rückleiter (1a, 1b) bilden.

6. Messwandler nach einem der Ansprüche 1 bis 5, dadurch gekennzeichnet, dass der elektrische Leiter (1) eine U-förmige Schleife (11) bildet und dass deren Hin- und Rückleiter die parallel zueinander verlaufenden Hin- und Rückleiter (1a, 1b) des elektrischen Leiters (1) sind.

7. Messwandler nach einem der Ansprüche 1 bis 5, dadurch gekennzeichnet, dass der elektrische Leiter (1) mindestens zwei U-förmige Schleifen (11a, 11b) bildet, die seitlich parallel nebeneinander angeordnet und elektrisch in Reihe geschaltet sind, wobei beide Leiter (16, 17 bzw. 18, 19) einer jeden Schlei-

fe (11a bzw. 11b) parallel deckend übereinander und die beiden Hinleiter (16, 18) einerseits und die beiden Rückleiter (17, 19) anderseits der beiden Schleifen (11a, 11b) jeweils in einer gleichen Ebene nebeneinander angeordnet sind, und dass die Luftspule (3;4) zwischen den beiden Hinleitern (16, 18) einerseits und den beiden Rückleitern (17, 19) anderseits angeordnet sind.

8. Messwandler nach einem der Ansprüche 1 bis 5, dadurch gekennzeichnet, dass der elektrische Leiter (1) mindestens zwei U-förmige Schleifen (11a, 11b) bildet, die deckend ineinander geschoben angeordnet und elektrisch in Reihe geschaltet sind, wobei die Leiter (16, 17, 18, 19) aller Schleifen (11a, 11b) parallel deckend übereinander anngeordnet sind, und dass die Luftspule (3;4) zwischen den beiden Hinleitern (16, 18) einerseits und den beiden Rückleitern (17, 19) anderseits angeordnet sind.

9. Messwandler nach einem der Ansprüche 2 bis 5, dadurch gekennzeichnnet, dass der elektricche Leiter (1) mindestens innerhalb des rohrförmigen Ringes aus zwei parallelen Leitern (20, 21) besteht, die mindestens einmal derart angeordnet sind, dass sie den rohrförmigen Ring zuerst in einer Richtung durchqueren, sich dann elektrisch isoliert kreuzen, um anschliessend den rohrförmigen Ring in umgekehrter Richtung erneut zu durchqueren, wobei die Luftspule (3;4) jeweils für beide Richtungen zwischen den beiden Leitern (20, 21) angeordnet ist.

10. Messwandler nach einem der Ansprüche 5 bis 9, dadurch gekennzeichnet, dass die Luftspule (3;4) auf einem Träger aus Isoliermaterial angeordnet ist.

11. Messwandler nach Anspruch 10, dadurch gekennzeichnet, dass der Träger ein Boden (10a) des Gehäuses (10) ist.

12. Messwandler nach Anspruch 11, dadurch gekennzeichnet, dass das Gehäuse (10) aus Keramik besteht.

13. Messwandler nach einem der Ansprüche 10 bis 12, dadurch gekennzeichnet, dass auf dem Träger noch zusätzlich elektronische Bauelemente angeordnet sind.

14. Messwandler nach einem der Ansprüche 2 bis 13, dadurch gekennzeichnet, dass der rohrförmige Ring aus einer Eisen-Nickel-Legierung besteht.

15. Messwandler nach einem der Ansprüche 2 bis 14, dadurch gekennzeichnet, dass der rohrförmige Ring auf seiner Mantelfläche von einer annähernd parallelen, ringförmigen und längeren Aussenabschirmung (12) umgeben ist.

16. Messwandler nach Anspruch 15, dadurch gekennzeichnet, dass die Aussenabschirmung (12) aus Tiefziehstahl besteht.

17. Messwandler nach Anspruch 15, dadurch gekennzeichnet, dass die Aussenabschirmung (12) aus einer Eisen-Nickel-Legierung besteht.

18. Messwandler nach einem der Ansprüche 15 bis 17, dadurch gekennzeichnet, dass zwischen dem rohrförmigen Ring und der Aussenabschirmung (12) ein räumlicher Abstand besteht.

## Revendications

1. Transformateur de mesure destiné à la mesure d'un courant (i) traversant un conducteur électrique (1), comportant une bobine à air (3; 4), un boîtier (10) en matière electriquement isolante et au moins un blindage ferromagnétique (2), la bobine à air (3; 4) étant disposée dans le boîtier (10) et entre respectivement un conducteur aller et un conducteur retour (1a, 1b), de tracés parallèles l'un à l'autre, du conducteur électrique (1) de telle manière que l'axe longitudinal de la bobine à air (3; 4) soit de tracé parallèle à la direction des champs magnétiques ($\vec{H}_a$, $\vec{H}_b$) qui sont créés par le courant (i) traversant le conducteur aller et retour (1a, 1b), et dans lequel le blindage ferromagnétique (2) entoure de facon électriquement isolante le conducteur aller et retour (1a, 1b), caractérisé en ce que le blindage ferromagnétique (2) possède la forme d'un anneau tubulaire, qui est traversé en direction longitudinale par le conducteur aller et retour (1a, 1b), en ce que la distance entre la surface d'enveloppe de la bobine à air (3; 4) et le conduit aller et retour (1a, 1b) est respectivement au maximum d'un millimètre, et que la bobine à air (3; 4) est une bobine plate, de sorte que d'une part le flux magnétique des champs magnétiques ($\vec{H}_a$, $\vec{H}_b$) est le plus possible saisi entièrement par la bobine à air (3; 4) et que d'autre part la bobine à air (3; 4) ne s'étend en direction axiale que sur une longueur partielle aussi petite que possible des lignes de champs magnétiques créées par le courant (i) et en ce que la bobine à air (3; 4) et le boîtier (10) constituent ensemble une unité modulaire, qui permet un montage simple, et non critique en ce qui concerne les tolérances mécaniques, de la bobine à air (3; 4) entre le conducteur aller et retour (1a, 1b).

2. Transformateur de mesure selon la revendication 1, caractérisé en ce que le blindage ferromagnétique (2) se compose d'au moins une tôle pliée annulaire.

3. Transformateur de mesure selon la revendication 2, caractérisé en ce que la longueur de l'anneau tubulaire est supérieure à son plus grand diamètre intérieur libre.

4. Transformateur de mesure selon la revendication 2 ou 3, caractérisé en ce que, pour une coupe transversale rectangulaire du conducteur électrique (1), la section transversale de l'anneau tubulaire perpendiculairement à l'axe longitudinal est, de même, de forme rectangulaire.

5. Transformateur de mesure selon l'une des revendications 1 à 4, caractérisé en ce que les parois du boîtier (10) constituent l'isolation électrique de la bobine à air (3;4) par rapport au conducteur aller et retour (1a, 1b).

6. Transformateur de mesure selon l'une des revendications 1 à 5, caractérisé en ce que le conducteur électrique (1) constitue une boucle en forme de U et en ce que les conducteurs aller et retour de celle-ci sont les conducteurs aller et retour parallèles l'un à l'autre (1a, 1b) du conducteur électrique (1).

7. Transformateur de mesure selon l'une des revendications 1 à 5, caractérisé en ce que le conducteur électrique (1) ccmprend au moins deux boucles en forme de U (11a, 11b), qui sont disposées parallèlement côte-à-côte et qui sont montees électriquement en série, les deux conducteurs (16, 17 ou 18, 19) de chaque boucle (11a, 11b) se recouvrant parallèlement l'un l'autre et les deux conducteurs aller (16, 18) d'une part et les deux conducteurs retour (17, 19) d'autre part des deux boucles (11a, 11b) étant respectivement disposés côte-à-côte dans un même plan, et en ce que la bobine à air (3; 4) est disposée d'une part entre les deux conducteurs aller (16, 18) et d'autre part entre les deux conducteurs retour (17, 19).

8. Transformateur de mesure selon l'une des revendications 1 à 5, caractérisé en ce que le conducteur électrique (1) constitue au moins deux boucles en forme de U (11a, 11b), qui sont disposées en étant décalées en se recouvrant l'une l'autre et qui sont décalées électriquement en série, les conducteurs (16, 17, 18, 19) de toutes les boucles (11a, 11b) étant disposés en se recouvrant parallèlement l'un l'autre, et en ce que la bobine à air (3; 4) est disposée d'une part entre les deux conducteurs aller (16, 18) et d'autre part entre les deux conducteurs retour (17, 19).

9. Transformateur de mesure selon l'une des revendications 2 à 5, caractérisé en ce que le conducteur électrique (1) se compose, à l'intérieur de l'anneau tubulaire, de deux conducteurs parallèles (20, 21) qui sont disposés au moins une fois de telle manière qu'ils traversent l'anneau tubulaire d'une part dans un sens, se croisent ensuite en étant électriquement isolés, pour traverser à nouveau ensuite l'anneau tubulaire dans le sens inverse, la bobine à air (3; 4) etant respectivement disposee pour les deux sens entre les deux conducteurs (20, 21).

10. Transformateur de mesure selon l'une des revendications 5 à 9, caractérisé en ce que la bobine à air (3; 4) est disposée sur un support en matière isolante.

11. Transformateur de mesure selon la revendication 10, caractérisé en ce que le support est un fond (10a) du boîtier (10).

12. Transformateur de mesure selon la revendication 11, caractérisé en ce que le boîtier (10) est en céramique.

13. Transformateur de mesure selon l'une des revendications 10 à 12, caractérisé en ce que des composants électroniques sont de plus disposés sur le support.

14. Transformateur de mesure selon l'une des revendications 2 à 13, caractérisé en ce que l'anneau tubulaire est en un alliage fer-nickel.

15. Transformateur de mesure selon l'une des revendications 2 à 14, caractérisé en ce que l'anneau tubulaire est entouré, sur sa surface d'enveloppe, par un blindage extérieur (12) à peu près parallèle, annulair et plus long.

16. Transformateur de mesure selon la revendication 15, caractérisé en ce que le blindage extérieur (12) est en acier à étirage profond.

17. Transformateur de mesure selon la revendication 15, caractérisé en ce que le blindage extérieur (12) est en un alliage fer-nickel.

18. Transformateur de mesure selon l'une des revendications 15 à 17, caractérisé en ce qu'il existe une distance spatiale entre l'anneau tubulaire et le blindage extérieur (12).

## Claims

1. A measuring transducer for measuring the current (i) flowing in an electrical conductor (1) comprising an air coil (3, 4), a housing (10) of electrically insulating material and at least one ferromagnetic shielding (2), wherein the air coil (3, 4) is arranged in the housing (10) and between respective mutually parallel out and back conductors (1a, 1b) of the electrical conductor (1) in such a way that the longitudinal axis of the air coil (3, 4) extends parallel to the direction of the magnetic fields ($\vec{H}_a$, $\vec{H}_b$) which are produced by the current (i) flowing in the out and back conductor (1a, 1b), and wherein the ferromagnetic shielding (2) electrically insulatedly surrounds the out and back conductor (1a, 1b), characterised in that the ferromagnetic shielding (2) is in the form of a tubular ring through which the out and back conductor (1a, 1b) passes in the longitudinal direction, that the spacing between the peripheral surface of the air coil (3, 4) and the out and back conductor (1a, 1b) is respectively at most a millimetre and the air coil (3, 4) is a flat coil so that on the one hand the magnetic flux of the magnetic fields ($\vec{H}_a$, $\vec{H}_b$) is caught as completely as possible by the air coil (3, 4) and on the other hand the air coil (3, 4) extends in the axial direction only over a minimum part of the length of the magnetic field lines produced by the current (i), and that the air coil (3, 4) and the housing (10) together form a structural unit which permits simple assembly, which is noncritical in relation to mechanical tolerances, of the air coil (3, 4) between the out and back conductor (1a, 1b).

2. A measuring transducer according to claim 1 characterised in that the ferromagnetic shielding (2) comprises at least one metal plate which is bent in an annular configuration.

3. A measuring transducer according to claim 2 characterised in that the length (L) of the tubular ring is greater than its greatest internal width.

4. A measuring transducer according to claim 2 or claim 3 characterised in that, with the electrical conductor (1) being of a rectangular cross-section, the cross-section, normal to the longitudinal axis, of the tubular ring is also rectangular.

5. A measuring transducer according to one of claims 1 to 4 characterised in that the walls of the housing (10) form the electrical insulation of the air coil (3, 4) relative to the out and back conductor (1a, 1b).

6. A measuring transducer according to one of claims 1 to 5 characterised in that the electrical conductor (1) forms a U-shaped loop (11) and that the out and back conductors thereof are the mutually parallel out and back conductors (1a, 1b) of the electrical conductor (1)

7. A measuring transducer according to one of claims 1 to 5 characterised in that the electrical conductor (1) forms at least two U-shaped loops (11a, 11b) which are arranged in laterally parallel juxtaposed relationship and which are electrically connected in series, wherein both conductors (16, 17 and 18, 19) of each loop (11 and 11b respectively) are arranged in parallel superposed relationship and the two out conductors (16, 18) on the one hand and the two back conductors (17, 19) on the other hand of the two loops (11a, 11b) are respectively arranged in juxtaposed relationship in the same plane and that the air coil (3, 4) are arranged between the two out conductors (16, 18) on the one hand and the two back conductors (17, 19) on the other hand.

8. A measuring transducer according to one of claims 1 to 5 characterised in that the electrical conductor (1) forms at least two U-shaped loops (11a, 11b) which are arranged in a position of being inserted in aligned relationship one into the other and which are electrically connected in series, wherein the conductors (16, 17, 18, 19) of all loops (11a, 11b) are arranged in parallel superposed aligned relationship and that the air coil (3, 4) are arranged between the two out conductors (16, 18) on the one hand and the two back conductors (17, 19) on the other hand.

9. A measuring transducer according to one of claims 2 to 5 characterised in that the electrical conductor (1) comprises at least within the tubular ring two parallel conductors (20, 21) which are arranged at least once in such a way that they firstly pass through the tubular ring in one direction, then cross in an electrically insulated condition in order then again to pass through the tubular ring in the opposite direction, wherein the air coil (3, 4) is arranged for each of the two directions between the two conductors (20, 21).

10. A measuring transducer according to one of claims 5 to 9 characterised in that the air coil (3, 4) is disposed on a carrier of insulating material.

11. A measuring transducer according to claim 10 characterised in that the carrier is a bottom (10a) of the housing (10).

12. A measuring transducer according to claim 11 characterised in that the housing (10) comprises ceramic.

13. A measuring transducer according to one of claims 10 to 12 characterised in that electronic components are also additionally disposed on the carrier.

14. A measuring transducer according to one of claims 2 to 13 characterised in that the tubular ring comprises an iron-nickel alloy.

15. A measuring transducer according to one of claims 2 to 14 characterised in that the tubular ring is surrounded on its peripheral surface by an approximately parallel, annular and longer outer shielding (12).

16. A measuring transducer according to claim 15 characterised in that the outer shielding (12) comprises deep-drawing steel.

17. A measuring transducer according to claim 15 characterised in that the outer shielding (12) comprises an iron-nickel alloy.

18. A measuring transducer according to one of claims 15 to 17 characterised in that there is a spatial distance between the tubular ring and the outer shielding (12).

# Fig.1

# Fig.2

# Fig.3

# Fig.4